# EUROPÄISCHE PATENTSCHRIFT

(11) **EP 1 966 615 B1**
(45) Veröffentlichungstag und Bekanntmachung des Hinweises auf die Patenterteilung: **27.11.2013**
(21) Anmeldenummer: 06830608.3
(22) Anmeldetag: 13.12.2006
(51) Int. Cl.: G01R 1/067, G01R 15/26

(54) **VORRICHTUNG UND TASTKOPF ZUR GALVANISCH ENTKOPPELTEN UEBERTRAGUNG EINES MESSSIGNALS**
DEVICE and PROBE FOR THE GALVANICALLY DECOUPLED TRANSMISSION OF A MEASURING SIGNAL
DISPOSITIF ET SONDE DE TRANSMISSION A DECOUPLAGE GALVANIQUE D'UN SIGNAL DE MESURE

(30) Priorität: 21.12.2005 DE 102005061683
(43) Veröffentlichungstag der Anmeldung: 10.09.2008
(73) Patentinhaber: Forschungsverbund Berlin e.V., 12489 Berlin (DE); Hoffmann, Thomas, 13437 Berlin (DE)
(72) Erfinder: HOFFMANN, Thomas, 13437 Berlin (DE); LIERO, Armin, 13187 Berlin (DE)
(74) Vertreter: Hengelhaupt, Jürgen
(86) Internationale Anmeldenummer: PCT/EP2006/069684
(87) Internationale Veröffentlichungsnummer: WO 2007/071608

(56) Entgegenhaltungen:
- DE-A1- 10 010 846
- DE-A1- 10 361 991
- DE-A1- 19 933 978
- DE-A1- 19 955 978
- US-A- 3 675 123
- US-A- 4 135 152
- US-A- 5 923 175
- US-A- 6 100 770
- US-A1- 2004 100 280

## Beschreibung

Die Erfindung betrifft eine Vorrichtung sowie einen Tastkopf zur galvanisch entkoppelten Ubertragung eines Messsignals mit den im Oberbegriff der Anspruche 1 und 9 genannten Merkmalen.

Bei der Entwicklung und Prufung elektrischer bzw. elektronischer Bauelemente, Baugruppen und Gerate mussen Signale von beliebigen Punkten eines Prüflings abgegriffen werden konnen.

Bei elektrischen Spannungen zum Beispiel werden oft Oszilloskope zur Erfassung und grafischen Darstellung eingesetzt. Da fast alle Oszilloskope Tischgerate sind, konnen sie nicht direkt mit dem Messobjekt kontaktiert werden, dazu werden Tastkopfe eingesetzt.

Ein Tastkopf ist dabei ein Mess-Adapter zum Anschließen eines Messgerates an einen Messpunkt in einer Schaltung. Aufgabe des Tastkopfes ist die möglichst unverfälschte Ubertragung des Messwe'rtes, möglichst ohne merkliche Beeinflussung des Prüflings. Ein Oszilloskop-Tastkopf besteht aus folgenden Teilen: Einer Tastspitze zur Kontaktierung mit dem Mess-Signal auf einer Leiterbahn, Kontakten eines Bauelementes o. a.; einem kurzen, flexiblen Draht mit Klemme zum Abgriff des Bezugspotenzials des Messsignals; einem Tastkopf-Körper zum Halten mit der Hand; sowie Kabel und Steckverbinder zur Ubertragung des Mess-Signals zum Oszilloskop.

Es gibt Anforderungen, die an alle Tastkopfe gestellt werden: Eine geringe Beeinflussung des Mess-Signals, insbesondere eine geringe Eingangskapazitat, eine originalgetreue Weiterleitung des Mess-Signals an das Oszilloskop, das heißt geringe Verzerrungen der Signalform sowie geringe Amplitudenfehler und ein hoher Dynamikbereich sind hier zu nennen.

Bei Messungen elektrischer Spannungen muss zweipolig abgegriffen und zum Oszilloskop ubertragen werden. Man kann den einen Pol "Mess-Signal", den anderen "Bezugspotenzial des Mess-Signals" nennen.

Das Bezugspotenzial des Mess-Signals wird vom Messobjekt zum Oszilloskop (Oszilloskop-Bezugspotenzial) durchgeschleift. Üblicherweise ist dieser Pol des Oszilloskops mit dem Gehause und weiter mit dem Schutzleiter des Stromversorgungsnetzes verbunden. Bei mehrkanaligen Messungen werden die Bezugspotenziale der Mess-Signale über das Oszilloskop miteinander verbunden.

Besitzt das Messobjekt mehrere Bezugspotenziale für die Mess-Signale und durfen diese nicht miteinander oder mit dem Schutzleiter des Stromversorgungsnetzes verbunden werden, so musste auf solche Messungen verzichtet werden.

Daher wird die galvanisch entkoppelte Ubertragung von Messsignalen bei vielen technischen Messaufgaben benötigt. Beispiele sind Oszilloskopmessungen an Stromversorgungen auf der Primär- und Sekundarseite oder im Steuer- und Leistungskreis elektrischer Antriebe.

Unter galvanischer Trennung versteht man den Fall, dass es für Ladungstrager keinen Weg gibt, aus einem Stromkreis in einen anderen, unmittelbar benachbarten Stromkreis zu fließen. Häufigster Anwendungsfall für die galvanische Trennung sind Transformatoren mit Verbindung zum offentlichen Stromnetz. Hier ist eine galvanische Trennung vorgeschrieben, die durch zwei elektrisch getrennte Spulen mit einem gemeinsamen Eisenkern realisiert werden.

Ein Informationsaustausch zwischen galvanisch getrennten Stromkreisen ist durch nicht-elektrische Ubertrager, zum Beispiel durch Optokoppler (optisch) oder Transformatoren (induktiv) moglich.

Bei Tastkopfen fur Ozilloskope realisieren Differenztastkopfe und optoelektronische Tastkopfsysteme eine "virtuelle" oder echte Entkopplung von Mess-Signal und Oszilloskop. Wo eine Entkopplung des Mess-Signals vom Oszilloskop nicht erforderlich ist, wird man Tastkopfe einsetzen, bei denen das Mess-Signal-Bezugspotenzial zum Oszilloskop durchgeschleift ist. Letztere sind vor allem kostengünstiger als marktubliche Differenztastkopfe oder optoelektronische Tastkopfsysteme.

Differenztastkopfe funktionieren nach folgendem Prinzip: Das Ausgangssignal zweier Tastnadeln wird auf einen im Tastkopf befindlichen Differenzverstarker gegeben. Oder es werden zwei Tastkopfe über Leitungen an einen Differenzverstarker angeschlossen. Der Differenzverstarker-Ausgang ist mit dem Oszilloskop verbunden.

Im Idealfall sind die beiden Differenzsignale durch den Differenzverstarker vollstandig vom Bezugspotenzial des Oszilloskops entkoppelt. Nachteilig an diesen Systemen ist jedoch ein endlicher Gleichtakt-Eingangsspannungsbereich. Der endliche Gleichtakt-Eingangsspannungsbereich des Differenzverstarkers setzt der Amplitude des Gleichtaktsignals Grenzen. Ferner sinkt die Gleichtaktunterdruckung mit steigender Frequenz des Gleichtaktsignals. Wahrend bei Gleichtaktsignalen kleiner Frequenz (z. B. 50Hz) auch mit low-cost-Differenz-Tastkopfen eine gute Gleichtaktunterdruckung erzielt wird, sind diese bei Gleichtaktsignalen hoher Frequenz oder Spannungs-Anstiegs-Geschwindigkeit oft unbrauchbar.

Auch ist die Abstrahlung bei Differenztastkopfen nachteilig. Üblicherweise sind die beiden Tastkopfe über Kabel mit dem Differenzverstarker verbunden. Dadurch werden Teile des Mess-Signals und dessen Bezugspotentials (Gleichtaktsignal) in die Umgebung abgestrahlt. Mit steigender Frequenz und Amplitude des Gleichtaktsignals erhoht sich die Abstrahlung. Diese Abstrahlung belastet das Mess-Signal und dessen Bezugspotenzial, es wird ungewollt verandert, und der Messwert reprasentiert auch bei perfekter Ubertragung des Signals nicht mehr das zu messende Signal im ungestorten Zustand.

Durch Einsatz hochwertiger Komponenten und aufwandiger Schaltungstechnik lassen sich mit "high-end"-Differenz-Tastkopfen einige Messungen, bei denen das Bezugspotenzial des Mess-Signals nicht mit dem Bezugssignal des Oszilloskops verbunden ist, verbessern. Nachteilig ist jedoch, dass diese Losungen sehr teuer sind.

Ferner sind Systeme mit optischer Ubertragung des Mess-Signals bekannt. Das Messsignal wird dabei auf einen optischen Trager moduliert, zum Beispiel durch Modulation der Strahlungsleistung einer Halbleiter-Laserdiode. Ubertragen wird das modulierte Licht über eine Glasfaser. Im Empfanger wird es zum Beispiel mittels Fotodiode wieder demoduliert. Dieses Verfahren erlaubt eine praktisch vollständige Entkopplung des Messsignals vom Oszilloskop. Das optische Signal ist weder störanfällig noch stort es.

Die DE 101 01 632 B4 und die WO 89/09413 A1 sowie die US 5,465,043 geben verschiedene laserbasierte Verfahren unter Verwendung von Lichtwellenleitern an.

In DE 101 01 632 B4 wird ein Oszilloskoptastkopf mit faseroptischem Sensor zur potentialfreien Erfassung elektrischer Großen vorgestellt.

Die WO 89/09413 A1 beschreibt einen Oszilloskoptastkopf mit faseroptischem Sensor zur potentialfreien Erfassung elektrischer Großen. Der Sensorkopf weist einen elektrooptischen Kristall auf, mittels dessen zugeführtes Licht mit einer Polarisation durch Einwirkung eines elektrischen Feldes beeinflusst wird. Der Unterschied zwischen ursprunglicher Polarisation und der veranderten Polarisation wird dann in eine elektrische Große umgewandelt. Bei der Ubertragung kommen Lichtwellenleiter zum Einsatz.

Ein Messkopf zur potential- und storfreien Erfassung der Intensität eines elektrischen Feldes oder des absoluten Wertes einer Spannung ist in der US 5,465,043 offenbart. Auch hier spiegelt die Veranderung der Lichtpolarisation die Feldstarke bzw. den Spannungswert wieder.

Es handelt sich hierbei um ein relativ aufwandiges Verfahren bezuglich des Bauelemente-Einsatzes und der Herstellung.

So benotigt die WO 89/09413 A1 im Tastkopf ein optisches System, das mechanisch zu befestigende und hinsichtlich ihrer Achse zu justierende Elemente wie einen Strahlteiler, einen Spiegel und Linsen aufweist, und in DE 101 01 632 B4 wird ein teurer elektrooptischer Sensor eingesetzt.

Dokument DE 103 61 991 A beschreibt einen telemetrisch abfragbaren passiven Potentialsensor auf Basis eines akustischen Oberwellenreflektors.

Weitere bekannte Losungen zur galvanisch entkoppelten Ubertragung über optische Lichtleiter benötigen auf der Sensorseite eine elektrische Spannungsversorgung für die elektronischen Komponenten wie Laser, LED oder Verstarker. Deren galvanisch entkoppelte Bereitstellung stellt eine zusatzliche Schwierigkeit dar, zum Beispiel durch großeren Platzbedarf und begrenzte Funktionsdauer einer Batterie. Induktive Ubertragungsarten sind in der Spannungsfestigkeit begrenzt und erzeugen eine parasitäre kapazitive Kopplung zwischen dem Sensor und der Auswerteeinrichtung.

Es ist daher Aufgabe der vorliegenden Erfindung, eine Vorrichtung sowie einen Tastkopf zur galvanisch entkoppelten Übertragung eines Messsignals anzugeben, die kostengunstig sind und ohne Spannungsversorgung auf Mess-Signal-Seite auskommen.

Diese Aufgabe wird erfindungsgemäß gelost durch die Merkmale im kennzeichnenden Teil der Anspruche 1 und 9 im Zusammenwirken mit den Merkmalen im Oberbegriff. Zweckmäßige Ausgestaltungen der Erfindung sind in den Unteranspruchen enthalten.

In der vorliegenden Anmeldung wird die Problematik erfindungsgemäß dadurch gelost, dass ein Mikrowellensignal von einem Transceiver über einen galvanisch entkoppelnden Wellenleiter auf einen Sensor gegeben wird. Im Sensor wird dieses Signal teilweise reflektiert, wobei die Amplitude und/oder Phase des reflektierten Mikrowellensignals die Information über den Messwert enthalt. Das reflektierte Mikrowellensignal lauft durch den selben Wellenleiter zuruck zum Transceiver und wird in diesem ausgewertet. Dies ist ein einfacher und kostengunstiger Aufbau, der insbesondere auf der Sensorseite im Allgemeinen durch die Nutzung der Reflexion keine Spannungsversorgung benotigt. Dadurch kann der Sensor auch sehr kompakt realisiert werden, was die Beeinflussung des Messsignals durch den Sensor minimiert. Im Falle der Anwendung als Potenzial getrennter Tastkopf für Oszilloskope gestattet dieser Aufbau eine gute Handhabbarkeit.

Dazu weist eine erfindungsgemaße Vorrichtung zur galvanisch entkoppelten Ubertragung eines Messsignals einen Transceiver für Mikrowellen auf, der über ein Mittel zur galvanisch entkoppelten Ubertragung von Mikrowellen mit einem Sensor verbunden ist.

Das Mittel zur galvanisch entkoppelten Ubertragung von Mikrowellen ist ein dielektrischer Wellenleiter oder ein Wellenleiter mit einer Mehrzahl galvanisch leitender Leitungsstucke, die voneinander isoliert hintereinander geschaltet sind. Der Transceiver ist ein Continuous Wave (CW) Signal Transceiver, ein Transceiver für amplitudenmodulierte, einschließlich gepulster Mikrowellensignale, ein Transceiver für frequenzmodulierte Mikrowellensignale oder ein Transceiver für Mikrowellensignale, bestehend aus mehreren überlagerten Frequenzen. Der Transceiver enthalt einen Oszillator und einen Demodulator. Der Demodulator ist bevorzugt als Mischer zwischen dem Oszillator-Signal und dem reflektierten Signal ausgefuhrt.

Der Sensor kann ein Sensor für elektrische Signale oder ein Sensor fur nichtelektrische Signale sein. Nimmt der Sensor ein nichtelektrisches Messsignal auf, so wandelt er es in ein elektrisches Messsignal. Der Sensor enthalt einen Reflektor und ein Element, das die Reflexion in einer das Mess-Signal charakterisierenden Weise verandert (Modulator). Der Modulator weist eine Halbleiterdiode, einen Transistor oder einen temperaturabhangigen Widerstand auf.

Vorteilhafterweise ist das Mittel zur Ubertragung des Mikrowellensignals zusammen mit dem Transceiver und dem Sensor auf einem Substrat integriert. Dies erlaubt die Miniaturisierung der Vorrichtung.

Durch die Reflektion des Signal im Sensor kommt dieser ohne zusatzliche Spannungsversorgung aus.

Der erfindungsgemaße Tastkopf zur galvanisch entkoppelten Ubertragung von Messsignalen, bestehend aus einer Tastspitze, einen Tastkopfkorper mit einem Gehause und einer Verbindung zu einem Messgerat ist dadurch gekennzeichnet, dass der Tastkopf obige erfindungsgemaße Vorrichtung zur galvanisch entkoppelten Ubertragung eines Messsignals aufweist, bestehend aus einem Transceiver für Mikrowellen, welcher über ein Mittel zur galvanisch entkoppelten Ubertragung von Mikrowellen mit einem Sensor verbunden ist.

Die Tastspitze weist eine Tastnadel und eine Eingangsschaltung auf. Der Tastkopf umfasst ferner einen Verstarker, der zwischen dem Transceiver und der Verbindung zu einem Messgerat angeordnet ist. Weiterhin kann der Tastkopf einen Microcontroller aufweisen, der mit dem Verstarker verbunden ist.

Entsprechend ist ein erfindungsgemaßes Verfahren zur galvanisch entkoppelten Ubertragung eines Messsignals dadurch gekennzeichnet, dass das Verfahren folgende Schritte umfasst: Senden eines Mikrowellensignals von einem Transceiver, Ubertragen des Mikrowellensignals vom Transceiver über ein galvanisch entkoppelndes Mittel zur Ubertragung von Mikrowellen zu einem Sensor, Reflektion des Signals im Sensor, wobei das Mikrowellen-Signal in einer den Messwert charakterisierenden Weise verandert wird, Ubertragen des reflektierten Mikrowellensignals vom Sensor über das galvanisch entkoppelnde Mittel zur Ubertragung von Mikrowellen zum Transceiver, und Auswertung des reflektierten Mikrowellensignals im Transceiver.

Das reflektierte Mikrowellensignal wird im Transceiverer hinsichtlich der Amplitude, der Phase, der Polarisation oder einer Kombination aus Amplitude, Phase und Polarisation ausgewertet, vorzugsweise in Relation zum Oszillator-Signal.

Vorteile der erfinderischen Losung liegen vor allen in der kostengunstigeren Ausführung, die sich gut miniaturisieren und integriert fertigen lasst.
Das Signal wird bei der Messung deutlich wenig belastet und lasst sich somit unverfalscht messen.

Die Erfindung wird nachstehend anhand emiger Ausfuhrungsbeispiele naher erlautert.

Es zeigt
- Fig. 1:: Die erfindungsgemäße Vorrichtung zur galvanisch entkoppelten Ubertragung von Signalen in schematischer Übersicht.
- Fig. 2:: Eine schematische Detailansicht der erfindungsgemaßen Vorrichtung in einem Ausfuhrungsbeispiel zur Spannungsmessung.
- Fig. 3:: Eine schematische Detailansicht des Sensors der erfindungsgemaßen Vorrichtung in einem Ausfuhrungsbeispiel zur Temperaturmessung.
- Fig. 4:: Eine schematische Ansicht eines erfindungsgemaßen Tastkopfs.

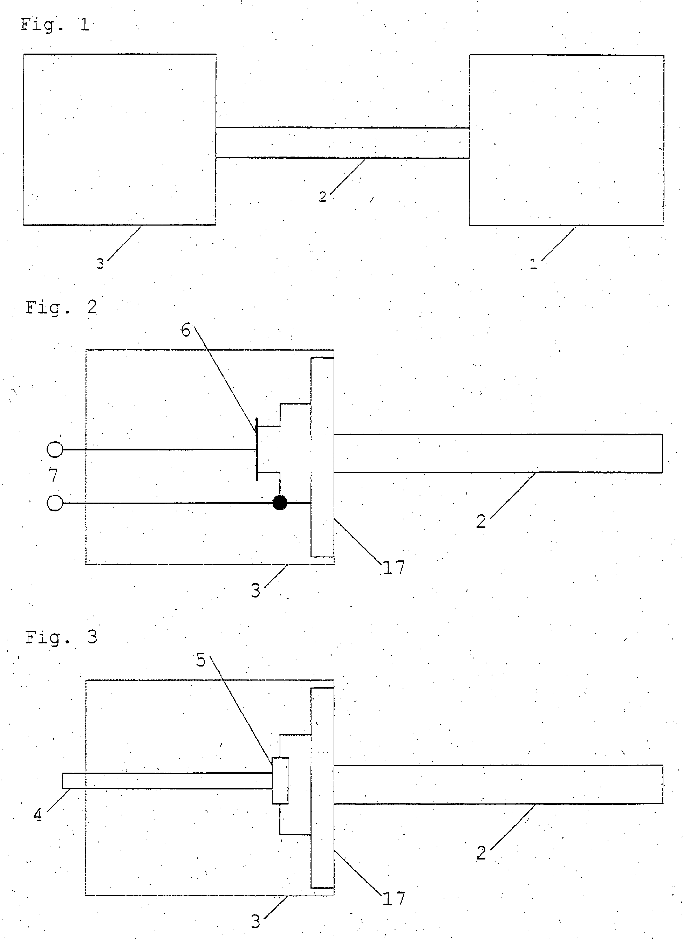

Die Anordnung der Fig. 1 besteht aus einem Transceiver 1, einem Mittel zur galvanisch entkoppelten Ubertragung von Mikrowellen und einem Sensor 3. Bevorzugt ist das Mittel zur Ubertragung von Mikrowellen als ein dielektrischer Wellenleiter 2 realisiert.

Der Transceiver 1 erzeugt ein Mikrowellensignal und wertet das vom Sensor 3 reflektierte Signal, aus. Er enthalt einen Oszillator für die gewunschte Mikrowellenfrequenz. Im einfachsten Fall kann das reflektierte Mikrowellensignal durch einen Mischer mit dem Oszillatorsignal multipliziert werden und liefert ein DC-Signal, das von der Amplitude und Phasenlage der Reflektion abhangt.

Das Mittel zur galvanisch entkoppelten Ubertragung von Mikrowellen kann zum Beispiel als dielektrischer Wellenleiter 2 realisiert werden. Zur Minimierung storender Einflusse kann eine Abschirmung vorgesehen werden.

Der Sensor 3 enthalt einen Reflektor 17 und einen Modulator zur Veränderung der Eigenschaften des Reflektors 17. Das Mess-Signal beeinflusst die Impedanz des Modulators und damit die Reflexionseigenschaften des Reflektors 17.

Die bevorzugte Ausführungsvariante des Sensors 3 zur Spannungsmessung ist in Fig. 2 dargestellt. Hier ist der Wellenleiter 2 mit dem Reflektor 17 verbunden und dieser mit dem Drain-Source-Kanal eines Transistors 6. Ein elektrischer Eingang 7 wird durch Gate und Source des Transistors 6 gebildet. An diesem Eingang 7 wird ein elektrisches Signal angelegt, das über die Widerstandsanderung des Dram-Source-Kanals das Eingangssignal auf die Reflektion des Mikrowellsignals, abbildet.

Eine weitere Realisierungsmoglichkeit des Sensors 3 zur Temperaturmessung ist in Fig. 3 dargestellt. Ein Ubergangselement 4 verbindet den Wellenleiter 2 mit den Anschlussen eines temperaturabhangugen Widerstandes 5, zum Beispiel PT 100. Die temperaturabhängige Fehlanpassung am Ausgang des Ubergangselementes 4 fuhrt zur gewunschten temperaturabhängigen Reflektion des Mikrowellensignals.

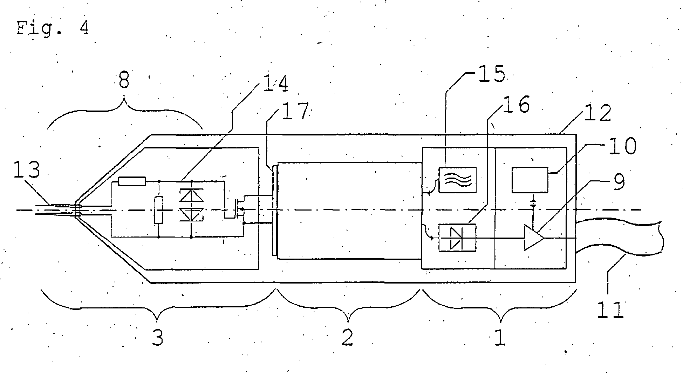

Fig. 4 zeigt eine schematische Ansicht des erfindungsgemaßen Tastkopfes. Bevorzugt entspricht die außere Form des Tastkopfes in etwa der eines Fullfederhalters. Transceiver 1, Mikrowellenleiter 2 und Sensor 3 bilden eine mechanische Einheit. Die funktionalen Einheiten des Tastkopfes sind ein Mittel zur Kontaktierung mit dem Messsignal, bevorzugt eine Tastspitze 8, der Sensor 3, der Transceiver 1, das Mittel zur Ubertragung von Mikrowellen und der Verstärker 9 und ggf. ein Mikrocontroller 10. Die Tastspitze 8 kann auch auswechselbar ausgebildet sein.

Die Tastspitze 8 enthalt bevorzugt eine Tastnadel 13 und eine kurze, flexible Leitung mit Mini-Klemme oder zwei Tastnadeln, die das Messsignal und dessen Bezugspotenzial kontaktieren. Die Tastnadeln (bzw. Tastnadel 13 + flexible Leitung) sind mit einer Eingangsschaltung 14 verbunden.

Die Eingangsschaltung 14 beinhaltet Elemente zur Abschwächung des Messsignals, zur Korrektur des Frequenzganges und zum Schutz des im Signalpfad folgenden aktiven Elementes, siehe Sensor 3.

In diesem Ausfuhrungsbeispiel sei der Reflektor 17 ein symmetrischer Dipol, das aktive Element ein MOSFET. Dessen Drain und Source sind mit jeweils einem Schenkel der Dipol-Antenne kontaktiert. An Gate und Source liegt Mess-Signal und Bezugspotenzial. Die sich mit dem Mess-Signal andernde Gate-Source-Spannung moduliert den Kanalwiderstand des MOSFETs. Der über dem Fußpunkt des Dipols liegende MOSFET-Kanal schließt den Dipol mehr oder weniger kurz. Dadurch werden in Abhängigkeit des Mess-Signals Phase und Amplitude der reflektierten Welle verandert.

Der Transceiver 1 beinhaltet in einem bevorzugten Ausfuhrungsbeispiel einen Mikrowellen-Oszillator 15 und einen Mischer und Demodulator 16. Die im Oszillator 15 generierte HF-Energie wird zum einen Teil zum Sensor bzw. Reflektor 17 geleitet, zum anderen Teil auf den Mischer 16 gegeben. Die reflektierte Welle wird im Mischer 16 der Oszillatorschwingung nichtlinear überlagert. Ändert sich die Phase und/oder Amplitude der reflektierten Welle, generiert das am Demodulator 16 eine sich andernde Spannung.

Das Mittel zur Ubertragung von Mikrowellen ist bevorzugt ein dielektrischer Wellenleiter 2. Er leitet die Mikrowelle vom Oszillator 15 zum Sensor/Reflektor 3 und zuruck auf den Mischer 16. Der dielektrische Wellenleiter 2 isoliert das Mess-Signal gegenuber dem angeschlossenen Oszilloskop (nicht gezeigt).

So ist auf der einen Seite (Tastnadel 13, Tastspitze 8, Sensor 3) alles elektrisch Leitende mit dem Mess-Signal verbunden. Eine galvanische Verbindung mit dem Oszilloskop besteht auf der anderen Seite (Transceiver 1, Verstärker 9, Leitung zum Oszilloskop 11).

Der Verstärker 9 verstarkt die am Demodulator 16 anliegende Spannung. Zusätzlich kann er nichtlineare Elemente und Schaltelemente enthalten. Die nichtlinearen Elemente können Nichtlinearitäten im Signalpfad (verursacht durch MOSFETs, Sensor 3 und Demodulator 16) ausgleichen und damit den nutzbaren Dynamikbereich vergroßern. Auch Schaltelemente konnen vorhanden sein, die zum Nullpunkt- und Verstarkungs-Abgleich dienen. Diese konnen durch einen Mikrocontroller 10 gesteuert werden.

Zusätzlich kann der Mikrokontroller 10 Signalisierungsfunktionen ubernehmen, z. B. Overload, Selbstkalibrierungs-Zyklus und eingestellte Verstarkung. Die Ausgangsimpedanz des Verstarkers 9 ist der Leitung zum Oszilloskop 11 angepasst.

Die Verwendung von Mikrowellen gegenuber Lichtwellen erlaubt es, die Vorrichtung und den Tastkopf zu miniaturisieren. Der Messsensor hat dabei in einem Ausfuhrungsbeispiel eine Große von ca. 0,1 cm³. Dies erlaubt eine kostengunstigere Ausfuhrung. Die Vorrichtung kann integriert auf einem Substrat gefertigt werden. Zum Beispiel können die Methoden der Dünnschichttechnologie auf eine Al₂O₃-Substrat angewandt werden. Auch wird durch die Miniaturisierung die Storfestigkeit der Anordnung erhoht.

Ferner erlaubt die erfindungsgemäße Vorrichtung die Bandbreite des Mess-Signals gegenuber Lichtwellenanwendungen zu erhohen. Die Mikrowellenfrequenz liegt bevorzugt zwischen 12 bis 30 GHz. Die Belastung des Messobjektes ist zudem sehr klein, typischerweise kleiner als 1 pF. Somit lassen sich breitbandige Messungen an hochohmigen Messpunkten (zum Beispiel Quellimpedanzen von 1 kOhm) durchfuhren, die sich mit laserbasierten Verfahren nach DE 101 01 632 B4, WO 89/09413 A1 und US 5,465,043 nicht durchfuhren lassen.

Des Weiteren konnen elektrisches Signale auch in stark elektromagnetisch gestorter Umgebung gemessen werden. Die Verwendung unterschiedlicher Bezugspotentiale stellt kein Problem dar.

Vorteilhafterweise ist die Messung nicht durch die Speicherkapazität eines Akkus, wie bei der Signalubertragung über Lichtleiter vonnöten, begrenzt. Es konnen sowohl analoge als auch digitale Signale gemessen werden. Kurzeste Impulse sind messbar.

Die Erfindung beschrankt sich nicht auf die hier dargestellten Ausführungsbeispiele. Vielmehr ist es möglich, durch Kombination und Modifikation der genannten Mittel und Merkmale weitere Ausführungsvarianten zu realisieren, ohne den Rahmen der Erfindung, wie in den Ansprüchen definiert, zu verlassen.

### Bezugszeichenliste

- 1: Transceiver
- 2: Mittel zur Übertragung von Mikrowellen
- 3: Sensor
- 4: Übergangselement
- 5: Widerstand
- 6: Transistor
- 7: Transistoreingang
- 8: Mittel zur Kontaktierung mit dem Messsignal
- 9: Verstärker
- 10: Mikrocontroller
- 11: Leitung zum Oszilloskop
- 12: Gehäuse,
- 13: Tastnadel
- 14: Eingangsschaltung
- 15: Oszillator
- 16: Mischer und Demodulator
- 17: Reflektor

## Patentansprüche

1. Vorrichtung zur galvanisch entkoppelten Spannungsmessung, bei dem ein Transceiver für Mikrowellen (1) über ein Mittel zur galvanisch entkoppelten Übertragung von Mikrowellen mit einem Sensor (3) verbunden ist, der keine Spannungsversorgung benötigt, wobei das Mittel zur galvanisch entkoppelten Übertragung der Mikrowellen ein dielektrischer Wellenleiter (2) ist **dadurch gekennzeichnet, dass**
der Sensor (3) einen als symmetrische Dipol-Antenne ausgeführten Reflektor (17) aufweist, wobei
der Sensor (3) einen MOSFET Transistor (6) zur Veränderung der Reflektion des Mikrowellensignals umfasst,
wobei Drain und Source des MOSFET Transistors (6) mit jeweils einem Schenkel des als symmetrische Dipol-Antenne ausgeführten Reflektors (17) verbunden sind,
wobei ein elektrischer Messeingang (7) der Vorrichtung durch Gate und Source des MOSFET Transistors (6) gebildet wird und wobei die Gate-Source-Spannung des MOSFET Transistors (6) den Kanalwiderstand desselben, welcher über dem Fußpunkt der Dipol-Antenne liegt, moduliert und damit Phase und Amplitude der an dem Reflektor (17) reflektieren Welle zu verändern in der Lage ist und wobei das Mittel zur galvanisch entkoppelten Übertragung von Mikrowellen zusammen mit dem Transceiver für Mikrowellen (1) und dem Sensor (3) auf einem Substrat integriert ist.

2. Vorrichtung nach Anspruch 1, **dadurch gekennzeichnet, dass** der Oszillator des Transceivers (1) ein CW-Signal-Oszillator ist, das heißt, dass das generierte Mikrowellensignal in Amplitude und Frequenz zeitlich konstant ist.

3. Vorrichtung nach Anspruch 1, **dadurch gekennzeichnet, dass** der Oszillator des Transceivers (1) ein Oszillator für amplitudenveränderliche, einschließlich gepulste Mikrowellensignale ist.

4. Vorrichtung nach Anspruch 1, **dadurch gekennzeichnet, dass** der Oszillator des Transceiver (1) ein Oszillator für frequenzmodulierte Mikrowellensignale ist.

5. Vorrichtung nach Anspruch 1, **dadurch gekennzeichnet, dass** der Transceiver (1) mehrere Oszillatoren aufweist, die Mikrowellensignale verschiedener Frequenz generieren, die überlagert werden.

6. Vorrichtung nach Anspruch 1, **dadurch gekennzeichnet, dass** der Transceiver (1) einen Demodulator (16) enthält.

7. Vorrichtung nach Anspruch 1, **dadurch gekennzeichnet, dass** im Transceiver (1) ein Mischer integriert ist, der das Oszillatorensignal mit dem reflektiertem Mikrowellensignal multipliziert.

8. Vorrichtung nach Anspruch 1, **dadurch gekennzeichnet, dass** das Mittel zur Übertragung des Mikrowellensignals durch einen flexiblen Wellenleiter (2) realisiert ist.

9. Vorrichtung nach Anspruch 1, **dadurch gekennzeichnet, dass** sie als Tastkopf ausgebildet ist, der einen Verstärker (9) und einen Mikrocontroller (10) umfasst, wobei der Verstärker (9) zwischen dem Transceiver (1) und der Verbindung zu einem Messgerät (11) angeordnet ist und der Mikrocontroller (10) mit dem Verstärker (9) verbunden ist.

## Claims

1. Device for galvanically decoupled voltage measurement, in which a transceiver for microwaves (1) is connected to a sensor (3) via a means for the galvanically decoupled transmission of microwaves, which sensor (3) requires no power supply, wherein the means for the galvanically decoupled transmission of the microwaves is a dielectric waveguide (2),
**characterized in that**
the sensor (3) has a reflector (17) designed as a symmetrical dipole antenna, wherein
the sensor (3) comprises a MOSFET transistor (6) for altering the reflection of the microwave signal,
wherein the drain and the source of the MOSFET transistor (6) are connected to one limb each of the reflector (17) designed as a symmetrical dipole antenna,
wherein an electric measuring input (7) of the device is formed by the gate and the source of the MOSFET transistor (6), and wherein the gate-source voltage of the MOSFET transistor (6) modulates the channel resistance thereof lying above the base of the dipole antenna and the gate-source voltage of the MOSFET transistor (6) is thus capable of altering the phase and the amplitude of the wave reflected from the reflector (17), and wherein the means for the galvanically decoupled transmission of microwaves is integrated, together with the transceiver for microwaves (1) and the sensor (3), on a substrate.

2. Device according to claim 1, **characterized in that** the oscillator of the transceiver (1) is a CW signal oscillator, which means that the generated microwave signal is constant in time with respect to its amplitude and frequency.

3. Device according to claim 1, **characterized in that** the oscillator of the transceiver (1) is an oscillator for amplitude-variant, including pulsed, microwave signals.

4. Device according to claim 1, **characterized in that** the oscillator of the transceiver (1) is an oscillator for frequency-modulated microwave signals.

5. Device according to claim 1, **characterized in that** the transceiver (1) has several oscillators that generate microwave signals that have different frequencies and are superimposed.

6. Device according to claim 1, **characterized in that** the transceiver (1) includes a demodulator (16).

7. Device according to claim 1, **characterized in that** a mixer is integrated in the transceiver (1), which is multiplying the oscillator signal with the reflected microwave signal.

8. Device according to claim 1, **characterized in that** the means for the transmission of the microwave signal is realized by a flexible waveguide (2).

9. Device according to claim 1, **characterized in that** it is designed as a contact probe that comprises an amplifier (9) and a microcontroller (10), wherein the amplifier (9) is arranged between the transceiver (1) and the connection to a measuring device (11) and the microcontroller (10) is connected to the amplifier (9).

## Revendications

1. Dispositif de mesure de tension à découplage galvanique, dans lequel un émetteur-récepteur pour micro-ondes (1) est, par le biais d'un moyen de transmission à découplage galvanique de micro-ondes, connecté à un capteur (3) qui n'a pas besoin d'alimentation en tension, le moyen de transmission à découplage galvanique de micro-ondes étant un guide d'onde (2) diélectrique, **caractérisé en ce que**
le capteur (3) présente un réflecteur (17) réalisé en tant qu'antenne dipôle symétrique,
le capteur (3) comprend un transistor MOSFET (6) destiné à faire varier la réflexion du signal micro-ondes,
le drain et la source du transistor MOSFET (6) étant respectivement connectés à une branche du réflecteur (17) réalisé en tant qu'antenne dipôle symétrique, une entrée de mesure (7) électrique du dispositif étant formée par la grille et la source du transistor MOSFET (6), et la tension grille-source du transistor MOSFET (6) modulant la résistance de canal de ce transistor qui se situe au-dessus du pied de l'antenne dipôle et étant de ce fait en mesure de faire varier la phase et l'amplitude de l'onde réfléchie sur le réflecteur (17), et le moyen de transmission à découplage galvanique de micro-ondes étant, ainsi que l'émetteur-récepteur pour micro-ondes (1) et le capteur (3), intégré sur un substrat.

2. Dispositif selon la revendication 1, **caractérisé en ce que** l'oscillateur de l'émetteur-récepteur (1) est un oscillateur à signaux entretenus, ce qui signifie que le signal micro-ondes généré est à amplitude et à fréquence constantes dans le temps.

3. Dispositif selon la revendication 1, **caractérisé en ce que** l'oscillateur de l'émetteur-récepteur (1) est un oscillateur pour signaux micro-ondes à amplitude variable, y compris des signaux micro-ondes pulsés.

4. Dispositif selon la revendication 1, **caractérisé en ce que** l'oscillateur de l'émetteur-récepteur (1) est un oscillateur pour signaux micro-ondes modulés en fréquence.

5. Dispositif selon la revendication 1, **caractérisé en ce que** l'émetteur-récepteur (1) présente plusieurs oscillateurs qui génèrent des signaux micro-ondes de différentes fréquences qui sont superposés.

6. Dispositif selon la revendication 1, **caractérisé en ce que** l'émetteur-récepteur (1) contient un démodulateur (16).

7. Dispositif selon la revendication 1, **caractérisé en ce que**, dans l'émetteur-récepteur (1), il est intégré un mélangeur qui multiplie le signal d'oscillateur par le signal micro-ondes réfléchi.

8. Dispositif selon la revendication 1, **caractérisé en ce que** le moyen de transmission du signal micro-ondes est réalisé par un guide d'onde (2) flexible.

9. Dispositif selon la revendication 1, **caractérisé en ce qu'**il est réalisé en tant que sonde qui comprend un amplificateur (9) et un microcontrôleur (10), l'amplificateur (9) étant disposé entre l'émetteur-récepteur (1) et la connexion à un appareil de mesure (11), et le microcontrôleur (10) étant connecté à l'amplificateur (9).
